# EUROPEAN PATENT SPECIFICATION

(11) **EP 2 684 063 B1**
(45) Date of publication and mention of the grant of the patent: **11.04.2018**
(21) Application number: 12712153.1
(22) Date of filing: 21.02.2012
(51) Int. Cl.: G01R 31/28, H04L 25/02

(54) **NON-CONTACT TESTING DEVICES FOR PRINTED CIRCUIT BOARDS TRANSPORTING HIGH-SPEED SIGNALS**
KONTAKTLOSE PRÜFVORRICHTUNGEN FÜR HOCHGESCHWINDIGKEITSSIGNALE TRANSPORTIERENDE LEITERPLATTEN
DISPOSITIFS DE TEST SANS CONTACT DESTINÉS À DES CARTES DE CIRCUITS IMPRIMÉS ACHEMINANT DES SIGNAUX À GRANDE VITESSE

(30) Priority: 07.03.2011 US 201113041937
(43) Date of publication of application: 15.01.2014
(73) Proprietor: Telefonaktiebolaget LM Ericsson (publ), 164 83 Stockholm (SE)
(72) Inventor: GUTERMAN, Alexandre, Nepean, Ontario K2G 6L6 (CA)
(74) Representative: Brann AB
(86) International application number: PCT/IB2012/050788
(87) International publication number: WO 2012/120396

(56) References cited:
- US-A- 5 638 402
- US-A- 6 016 086
- US-A1- 2004 073 737
- H. OSAKA ET AL: "High-speed, high-bandwidth DRAM memory bus with crosstalk transfer logic (XTL) interface", HOT 9 INTERCONNECTS. SYMPOSIUM ON HIGH PERFORMANCE INTERCONNECTS, 1 January 2001 (2001-01-01), pages 63-67, XP55031188, DOI: 10.1109/HIS.2001.946695 ISBN: 978-0-76-951357-7
- UEMATSU Y ET AL: "Time-domain analysis of the signal integrity of a 1-Gbps 4-module memory bus with a broadband ceramic directional coupier designed in the frequency domain", ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, vol. 2, 1 June 2004 (2004-06-01), pages 1746-1751, XP010715234, DOI: 10.1109/ECTC.2004.1320354 ISBN: 978-0-7803-8365-4
- MOORE B ET AL: "High throughput non-contact SiP testing", INTERNATIONAL TEST CONFERENCE 2007, 23-25 OCT.2007, SANTA CLARA, CA, USA, IEEE, PISCATAWAY, NJ, USA, 1 October 2007 (2007-10-01), pages 1-10, XP031206977, DOI: 10.1109/TEST.2007.4437595 ISBN: 978-1-4244-1127-6
- GUTERMAN A ET AL: "Point-to-multipoint gigabit backplane design", ELECTROMAGNETIC COMPATIBILITY, 2003. EMC '03. 2003 IEEE INTERNATIONAL SYMPOSIUM ON ISTANBUL, TURKEY 11-16 MAY 2003, PISCATAWAY, NJ, USA,IEEE, vol. 2, 11 May 2003 (2003-05-11), pages 1106-1109, XP010796131, ISBN: 978-0-7803-7779-0 cited in the application

## Description

### TECHNICAL FIELD

The present invention generally relates to devices and methods used for testing high-speed signals on printed circuit boards, and, in particular, to using the crosstalk effect for a non-contact testing technique.

### BACKGROUND

Worldwide development of communication gears towards higher and higher speed signals. The term "high-speed" may be considered as characterizing the data rate or alternatively the slew rate. Since the digital signals have two states "0" and "1", the transmission speed is limited by a circuit capacity to preserve voltage levels and waveforms to a degree which enables accurately recognizing the state in each time interval (a duration of which decreases with the increase of the data rate), thus, achieving a low bit-error rate. Relative to the data rate, currently digital signals having data rates over 100 Mbps are considered to be high-speed signals but, as technology develops, the term "high" may become associated to higher data rates than 100 Mbps. The technological progress allows higher and higher the data rates while keeping the bit error rates at low/acceptable level.

The slew rate represents the maximum rate of change of a signal at any point in a circuit. The slew rate reflects even more directly the quality of the underlying hardware to maintain the signal integrity, because it relates to the degrading of the signal shape during transmission (which shape may be different from the rectangular shape of the digital signals). The term "high-speed signal(s)" as used hereinafter covers both meanings, standing for high data rate and/or high slew rate signals.

Printed circuit boards (PCBs) used in transporting and processing high-speed signals are monitored for signal integrity and tested for compliance to standards and for detection and location of stuck-at and transient or soft fault, using off-line and/or in-circuit testing techniques. Conventionally, test points are connected directly to electrical nodes to probe and measure the signals on the PCBs. A conventional contact testing point comprises an interconnect track and a test pad or via, and is further connected to probing circuitry from an automatic testing equipment (ATE), from a measurement instrument or from an in-circuit testing device. The conventional testing point components and the probing circuitry are loads that affect the signal during probing and testing. These loads disturb the measured signals and therefore the results of these measurements do not reflect the normal operation conditions.

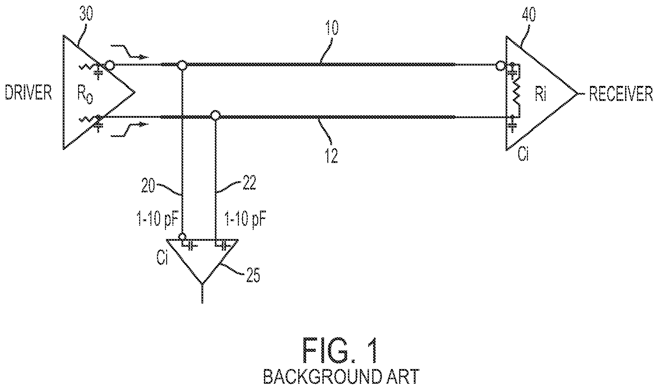

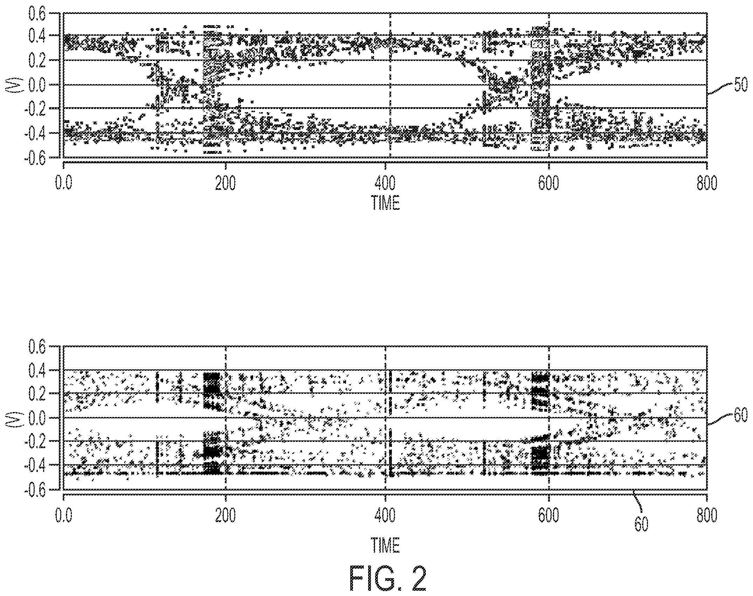

A schematic diagram on a conventional contact testing device is illustrated in Figure 1, where the interconnect track lines 20 and 22 are connected to the signal lines 10 and 12 through which signal propagates from a driver 30 to a receiver 40. The conventional contact testing device, which includes test pads, interconnect track lines 20 and 22 and a test signal receiver 25, has a capacitance of 1-10 pF. The high-speed signal output by the driver 30, which is illustrated in graph 50 of voltage versus time in Figure 2, suffers a slew degradation, a deterministic jitter, and eye closure as illustrated in graph 60 of voltage versus time diagram of Figure 2, due to the presence of the conventional contact testing device. Therefore, a higher bit error rate (BER) occurs during a measurement than during a normal operation (when the conventional contact testing device is not attached).

Crosstalk is a phenomenon occurring in electronic circuit by which a signal transmitted on one circuit or channel creates an echo in another circuit or channel. In PCB design, this phenomenon is viewed as undesirable and various techniques are employed to minimize its impact on the intended signals. However, sometimes the phenomenon may be employed for achieving desirable outcomes. For example, U.S. Patent 6,016,086 (incorporated herewith by reference) discloses a bus for high signal quality interconnections, comprising non-contact couplers terminated by different impedances, for producing at least one common mode reflection, under-damping the signal and/or reducing the common mode noise. These non-contact couplers cause the reflections from vias, connectors and other like impedance discontinuities to be re-reflected in common mode so that they are rejected by a differential receiver. In another example, described in the paper "Point-to-multipoint Gigabit Backplane Design" by Guterman, A. and Zani, R. (which paper was published in Electromagnetic Compatibility, 2003. EMC '03. 2003, vol. 2, 1106- 1109, ISBN: 0-7803-7779-6 and is incorporated herewith by reference) a contactless midplane is used to enhance backplane performance.

Nowadays, due to increasing data-rates and higher quality requirements, additional loads and alteration of the tested signals occurring when using conventional contact test points cannot be tolerated, being detrimental to signal integrity and performance.

Accordingly, it would be desirable to develop new techniques and devices usable off-line or performing in-circuit testing, to monitor signal integrity, determine compliance to standards and/or detection/location of stuck-at and transient /soft faults, which new techniques to avoid the afore-described problems and drawbacks.

### DESCRIPTION OF THE RELEVANT BACKGROUND ART

Publication "High-speed, high-bandwidth DRAM memory bus with Crosstalk Transfer Logic (XTL) interface", HOT 9 INTERCONNECTS SYMPOSIUM ON HIGH PERFORMANCE INTERCONNECTS, 1 January 2001, pages 63-67, by Osaka et al. discloses a crosstalk transfer logic digital Interface one-to-many connection that can be used as a memory bus.

Publication "Time-domain analysis of the signal Integrity of a 1-Gbps 4-module memory bus with a broadband ceramic directional coupler designed In the frequency domain", ELECTRONIC COMPONENTS AND TECHNOLOGY, 2004, ECTC '04 PROCEEDINGSS LAS VEAS, NV, USA, JUNE 1-3, 2004 PSCATAWAY, NJ, USA, IEEE, vol. 2, 1 June 2004, pages 1746-1751 by Uematsu et al. discloses a ceramic directional coupler for use in 1Gbps 4-module memory bus.

United States Patent Publication No. US 5,638,402 A to Osaka et al. discloses the use of a pair of bus transceivers to produce capacitive and inductive coupling between bus connecting lines.

United States Patent Publication No. US 2004/073737 A1 to Simon et al. discloses a mechanism for supporting high digital bandwidth in a multi-drop bus system.

Publication "High throughput non-contact SiP testing", INTERNATIONAL TEST CONFERENCE 2007, 23-25 OCT 2007, SANTA CLARA, CA, USA, IEEE, PISCATAWAY, NJ, USA, 1 October 2007, pages 1-10 by Moore et al. discloses a non-contact method for parallel testing of System-in-Package (SiP) assemblies using GHz short-range near field communications to transfer bi-directional data.

### SUMMARY

Non-contact testing devices according to various embodiments have less impact on the tested signals than the conventional contact testing points. Some of the design parameters that can be tuned to optimize testing for different situations evidence particular advantages.

According to one exemplary embodiment, a method of testing high-speed signals propagating along at least one signal track on a signal layer of a printed circuit board (PCB) is provided. The method includes forming a non-contact testing track on a layer of the PCB, the non-contact testing track having at least one portion substantially parallel with the at least one signal track. The method further includes connecting a testing point to an end of the non-contact testing track to enable measuring a crosstalk signal corresponding to the tested signal.

According to another exemplary embodiment, a method of testing high-speed signals propagating along at least one signal track on a signal layer of a printed circuit board (PCB) is provided. The method includes carving a moat in a reference layer of the PCB adjacent to the signal layer, to form a non-contact testing track having at least one portion substantially parallel with the at least one signal track. The method further includes connecting a testing point to an end of the non-contact testing track away from a non-carved surface of the reference layer, to enable measuring a crosstalk signal corresponding to the tested signal.

According to another exemplary embodiment, a non-contact testing device formed on a printed circuit board (PCB), to enable testing high-speed signals propagating along at least one signal track located on a signal layer of the PCB includes a non-contact testing track and a testing point. The non-contact testing track is formed on a layer of the PCB, and has at least one portion substantially parallel with the at least one signal track. The testing point is located on an end of the non-contact testing track.

According to another embodiment, a non-contact testing device formed on a printed circuit board (PCB), to enable testing high-speed signals propagating along at least one signal track located on a signal layer of the PCB includes a non-contact testing track and a testing point. The non-contact testing track is formed by etching a moat on a reference layer of the PCB, the reference layer being adjacent to the signal layer, and the non-contact testing track having at least one portion substantially parallel with the at least one signal track. The testing point is located at an end of the non-contact testing track away from a non-carved surface of the reference layer. The present invention is thus directed to a method of testing high-speed signals on a PCB according to the wording of claim 1 and to a non-contact testing device formed on a PCB according to the wording of claim 7. The dependent claims describe advantageous embodiments of the invention.

### BRIEF DESCRIPTION OF THE DRAWINGS

The accompanying drawings, which are incorporated in and constitute a part of the specification, illustrate one or more embodiments and, together with the description, explain these embodiments. In the drawings:
Figure 1 is a schematic diagram of a conventional contact testing device;
Figure 2 is a graph illustrating a voltage versus time for a high-speed signal without a conventional contact testing device and with a conventional contact testing device;
Figure 3A is a flow diagram of a method of testing high-speed signals propagating along at least one signal track on a signal layer of a printed circuit board according to an exemplary embodiment;
Figure 3B is a flow diagram of a method of testing high-speed signals propagating along at least one signal track on a signal layer of a printed circuit board according to another exemplary embodiment;
Figure 4 is a schematic diagram of a non-contact testing point according to an exemplary embodiment;
Figure 5 is a graph illustrating a voltage versus time for a high-speed signal without a non-contact testing point and with a non-contact testing point according to an exemplary embodiment;
Figures 6A and 6B illustrates location along signal lines of non-contact testing tracks for different topologies of the signal lines, according to exemplary embodiments;
Figures 7A and 7B illustrate evolution for a crosstalk signal corresponding to a saturation crosstalk regime and to a non-saturation crosstalk regime respectively, according to exemplary embodiments;
Figure 8 is a graph illustrating evolution of crosstalk signals corresponding to high-speed signals for the saturation crosstalk regime, the non-saturation crosstalk regime and on the verge of passing from the non-saturation crosstalk regime to the saturation crosstalk regime, according to exemplary embodiments;
Figure 9 is a graph illustrating the effect of the data rates on the amplitude of the crosstalk signal, according to an exemplary embodiment;
Figure 10 is a graph illustrating the effect of capacitive loads corresponding to different coupler lengths, on the amplitude of the crosstalk signal, according to an exemplary embodiment;
Figure 11 illustrates exemplary embodiments of non-contact testing devices located on signal layers of a PCB;
Figure 12 is a graph illustrating the effect of the separation between the signal track and the track of the non-contact testing device, on the amplitude of the crosstalk signal, according to an exemplary embodiment;
Figure 13 illustrates a plane view of a non-contact testing device formed on a reference plane, according to an exemplary embodiment;
Figure 14 illustrates exemplary embodiments of non-contact testing devices located on reference layers of the PCB;
Figure 15 illustrates a plane view of a non-contact testing device formed on a reference plane, according to another exemplary embodiment;
Figure 16 illustrates a PCB sectional view of a non-contact testing device formed on a shadow ground plane according to an exemplary embodiment;
Figure 17 is a graph illustrating the effect of different manners of terminating the non-contact testing tracks on the crosstalk signals, according to exemplary embodiments;
Figure 18 is a graph illustrating the effect of different manners of forming non-contact testing tracks on the crosstalk signals terminated directly to ground, according to exemplary embodiments;
Figure 19 is a schematic diagram of a complementary non-contact testing device according to an embodiment;
Figure 20 illustrates simulations of a signal reaching a receiver and of a corresponding crosstalk signal acquired by a non-contact testing device located close to the receiver, according to an exemplary embodiment; and
Figure 21 illustrates simulations of a signal output by a driver and of a corresponding crosstalk signal acquired by a non-contact testing device located close to the driver, according to an exemplary embodiment.

### DETAILED DESCRIPTION

The following description of the exemplary embodiments refers to the accompanying drawings. The same reference numbers in different drawings identify the same or similar elements. The following detailed description does not limit the invention. Instead, the scope of the invention is defined by the appended claims. The following embodiments are discussed, for simplicity, with regard to the terminology and structure of printed circuit boards used for transmitting high-speed signals. However, the embodiments to be discussed next are not limited to these systems but may be applied to other existing electronics hardware used in transmitting signals.

Reference throughout the specification to "one embodiment" or "an embodiment" means that a particular feature, structure, or characteristic described in connection with an embodiment is included in at least one embodiment of the present invention. Thus, the appearance of the phrases "in one embodiment" or "in an embodiment" in various places throughout the specification is not necessarily all referring to the same embodiment. Further, the particular features, structures or characteristics may be combined in any suitable manner in one or more embodiments.

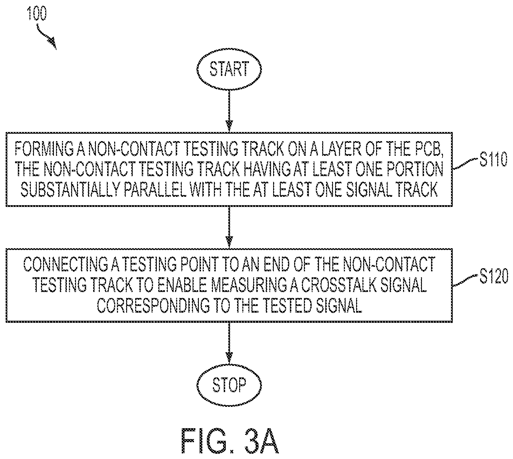

A flow diagram of method 100 of testing high-speed signals transmitted along a track on a signal layer of a printed circuit board (PCB), according to an exemplary embodiment, is illustrated in Figure 3A. The method 100 includes forming a non-contact testing track on a layer of the PCB, at S110. The non-contact testing track has at least one portion substantially parallel with the signal track. The term "substantially parallel" used here includes the situation in which the non-contact testing track is formed on another layer than the signal layer. Further, at S120, the method 100 includes connecting a testing point to an end of the non-contact testing track to enable measuring a cross-talk signal corresponding to the tested signal.

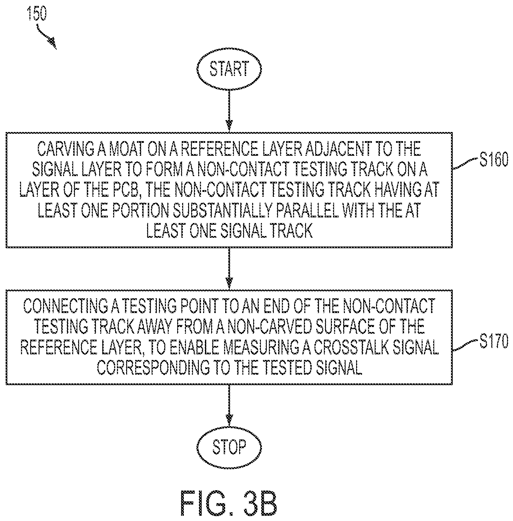

A flow diagram of method 150 of testing high-speed signals transmitted along a track on a signal layer of a printed circuit board (PCB), according to another exemplary embodiment, is illustrated in Figure 3B. The method 150 includes carving a moat on a reference layer adjacent to the signal layer to form a non-contact testing track, at S160. The non-contact testing track has at least one portion substantially parallel with the signal track. Further, at S170, the method 150 includes connecting a testing point to an end of the non-contact testing track away from a non-carved surface of the reference layer, to enable measuring a cross-talk signal corresponding to the tested signal.

When a signal (e.g., a digital signal) is transmitted along an interconnect track the crosstalk phenomenon occurs and an echo signal is produced in the portion of the non-contact testing track which is substantially parallel with the signal track.

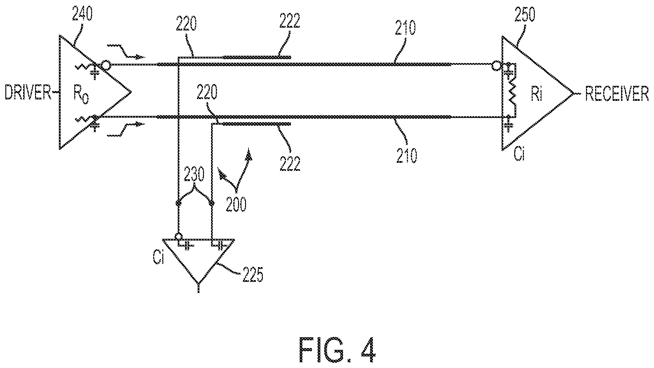

Figure 4 is a schematic diagram of a non-contact testing point setup. Although high-speed signals may be transmitted using a single line, the differential lines carrying complementary signals are more frequently used due to their advantages (e.g., tolerance to ground offsets, suitability for usage with low voltage electronics, resistance to interferences, etc.). The setup of Figure 4 illustrates differential lines 210 along which a signal (e.g., a digital signal) propagates from a driver 240 to a receiver 250.

A non-contact testing device 200 includes non-contact testing tracks 220 having parallel portions 222 and ending at a testing point 230. Due to the crosstalk phenomenon, the signal passing through the differential lines 210 yields the echo signal in the parallel portions 222 of the non-contact testing tracks 220. Note that in principle, a single parallel track may also be used, but double tracks 222 are used to pick up complementary signals for the same reasons as using the differential lines instead of a single line. The echo signals occurring in the parallel portions 222 may be input to an amplifier 225. The non-contact testing tracks other than the parallel portions 222 and the amplifier 225 have a capacitance of 1-10pF similar to the capacitance in the contact testing device case. The equivalent capacitance of the non-contact testing device 200 is that of a capacitor of 1-10 pF (corresponding to the connecting lines 220) in series with a capacitor of less than 0.1 pF due to the crosstalk coupling of the parallel portion. Thus, the equivalent capacitance of the non-contact testing device 200 is less than 0.1 pF resulting in a substantial lower load and signal degradation than the conventional contact testing device.

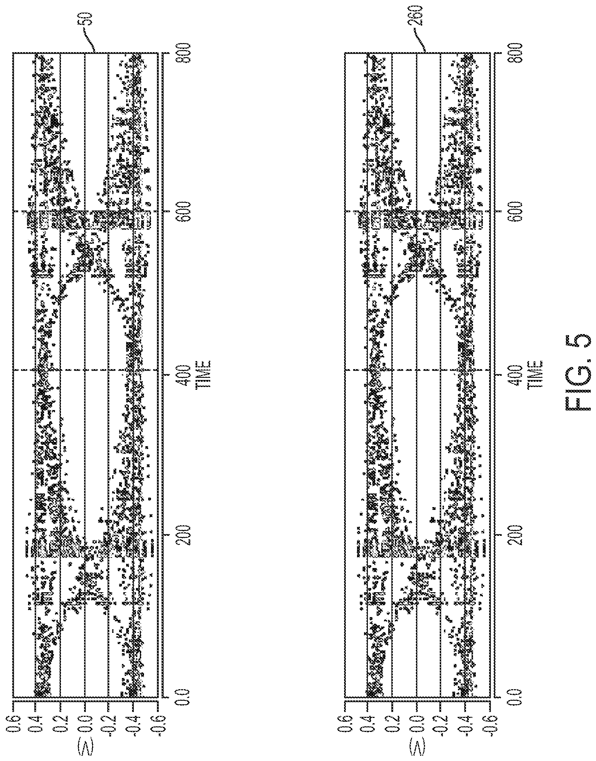

In the presence of the non-contact testing device 200, a high-speed signal output by the driver 240, which is illustrated in graph 50 of voltage versus time in Figure 5 (the same as in Figure 2), suffers less slew degradation, deterministic jitter, and eye closure, and, thus, has a lower BER as illustrated in graph 260, than in the presence of a conventional contact testing device as illustrated in graph 60 of Figure 2.

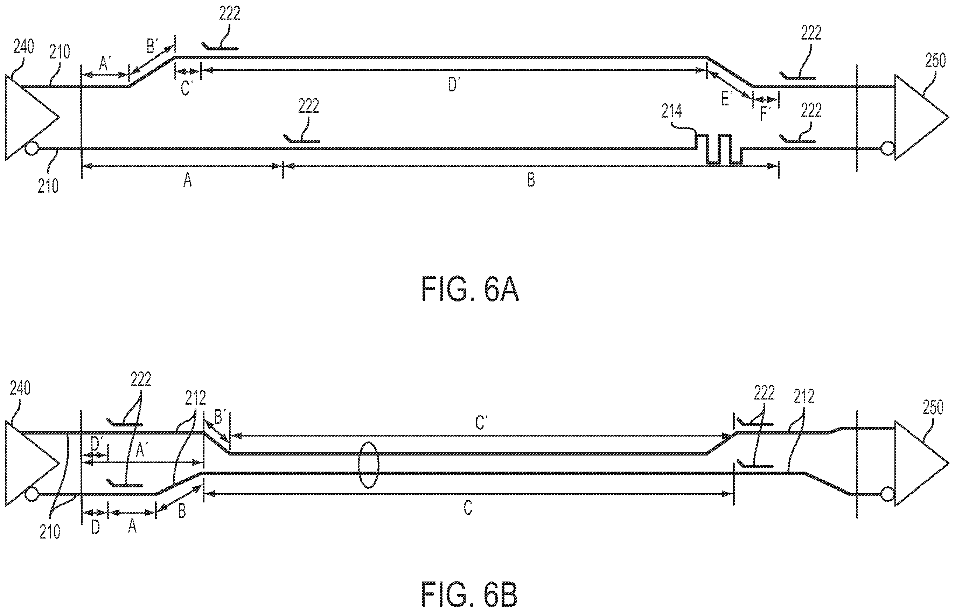

The schematic diagram in Figure 4, illustrates the portions 222 as being positioned at the same 'electrical' distance from the driver 240 (or the receiver 250) and the distance between the differential lines 210 as being constant throughout the path between the driver 240 and the receiver 250. However, the reality of PCBs design is usually more complex and features of the lines along which signal is transmitted impact the manner in which the non-contact testing tracks are formed. For example, when the driver 240 and the receiver 250 are close to each other (i.e., a short distance therebetween), the differential lines 210 are usually routed apart from each other as single ended lines, farther apart from each other as illustrated in Figure 6A. On the other hand, when the driver 240 and the receiver 250 are farther apart, often the differential lines 210 are routed to be closer to each other using breakout tracks 212, to be tightly coupled as illustrated in Figure 6B. In both cases, the total lengths of the two lines are matched, i.e., in Figure 6B, A+B+C=A'+B'+C', and, in Figure 6A, A+B=A'+B'+C'+D'+E'+F' (note here B includes a serpentine 214 included in portion B to achieve the same length). The pairs of parallel portions 222 (plural possible positions are illustrated) are placed at the same electrical length, preferably in areas where the coupling between the differential lines is smaller. Thus, in Figure 6A, A'+B'+C'=A, and in Figure 6B, D=D'.

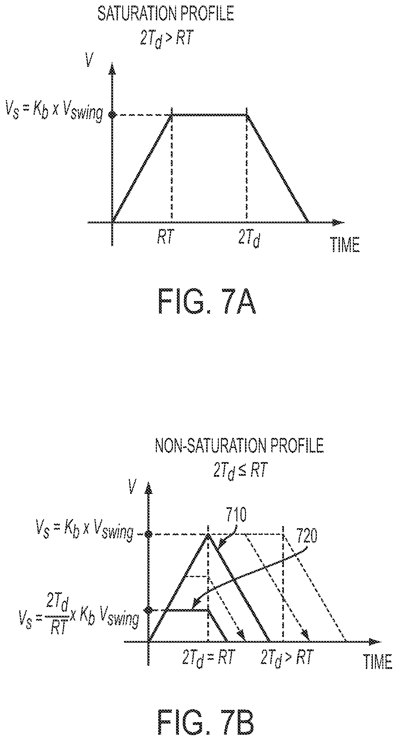

Depending on geometry, two types of crosstalk regime can occur when a non-contact testing device is used: (a) a saturation regime and (b) a non-saturation regime. Two time parameters interplay in determining the crosstalk regime: the flight-time and the rise-time. The flight-time (T_{d}) is the time of propagation of the signal from one end to the other of the parallel portion of the non-contact track. The rise-time (RT) is a time necessary for the signal to reach a maximum potential value after switching from a low to a high voltage. Figure 7A illustrates evolution (i.e., the time is represented along the x-axis of the graph) of a voltage (represented on y-axis) acquired in the non-contact testing track for the saturation regime. Thus, if the rise-time is less than twice the flight-time (RT<2T_{d}), the signal reaches a maximum potential value Vₛ equal to a product of a coupling coefficient K_{b} between the signal line (e.g., 210) and the parallel portion (e.g., 222) of the non-contact track and a potential difference on the signal line when switching between states V_{swing} (i.e., Vₛ = K_{b}×V_{swing}). When the crosstalk regime is the saturation regime this maximum value is maintained for a while, before decreasing.

Figure 7B illustrates evolution of voltage on the non-contact testing track in the non-saturation regime (when RT≥2Td). On the verge of the saturation 710, when RT=2T_{d}, the potential rises to the maximum value for the saturation regime (i.e., Vₛ = K_{b}×V_{swing}) and decreases immediately. If RT<2T_{d}, as illustrated by line 720, before decreasing, the potential rises to a value lower than the maximum value for the saturation regime Vₛ = 2T_{d}/RT×K_{b}×V_{swing}.

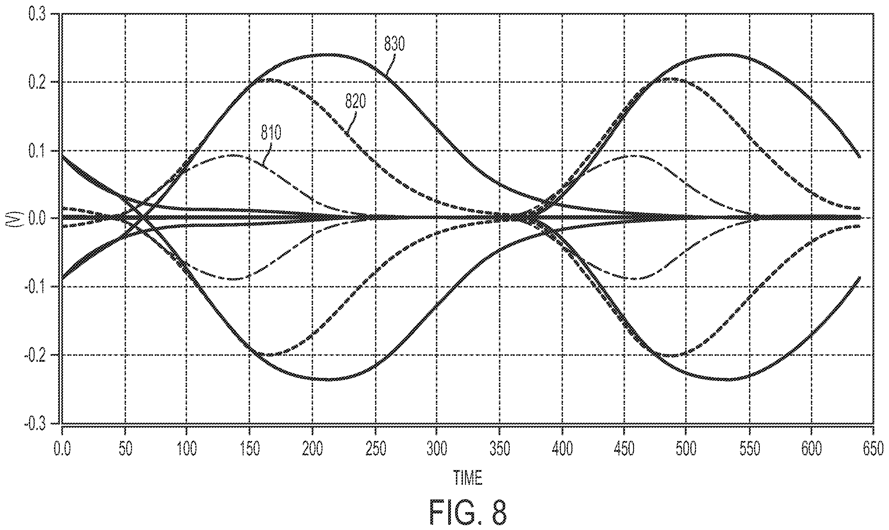

The saturation regime means a higher load on the system due to the presence of the non-contact testing device. On the other hand, one would prefer to take full advantage of the sensitivity of a measurement device and thus reaching the maximum potential value. Therefore, preferably, for an expected data rate, the length of the parallel portion of the testing track is selected such as the crosstalk signal to be on the verge of saturation, i.e., at a limit between the saturation regime and the non-saturation regime. Figure 8 illustrates amplitude (potential) of signals acquired by a non-contact testing device as a function of time. Line 810 corresponds to the non-saturation regime, line 820 to the verge of saturation, and line 830 corresponds to the saturation regime.

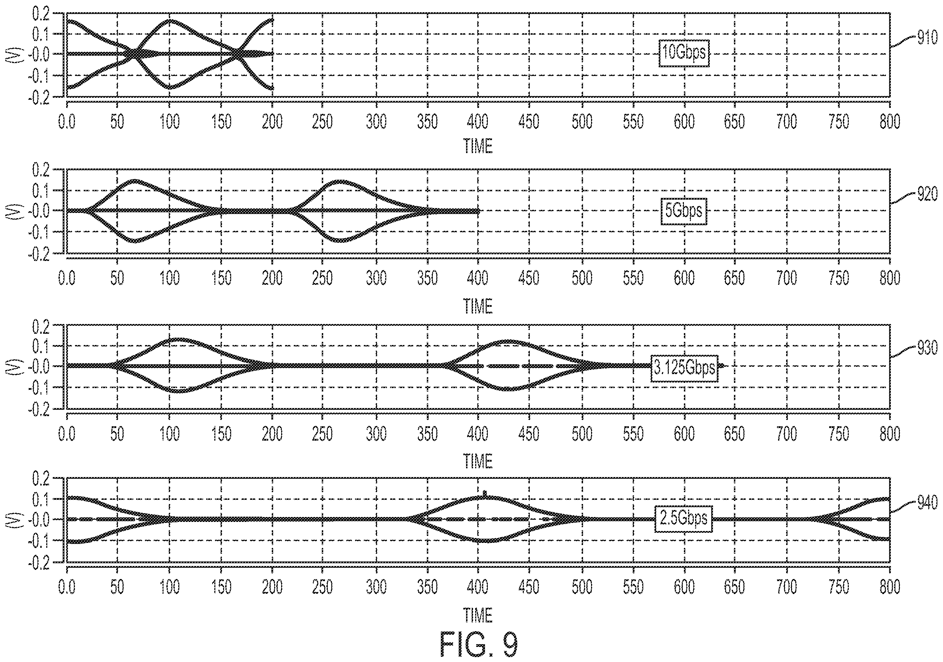

Once a non-contact testing track is formed on a PCB, the evolution of the signals acquired by a non-contact testing device depends also by the data rate of the data signal transmitted along the tested line. For example in Figure 9, for the same non-contact testing device, the first graph 910, corresponds to a data rate of 10 Gbps, the second graph 920, corresponds to a data rate of 5 Gbps, the third graph 930, corresponds to a data rate of 3.125 Gbps, and the fourth graph 940, corresponds to a data rate of 2.5 Gbps.

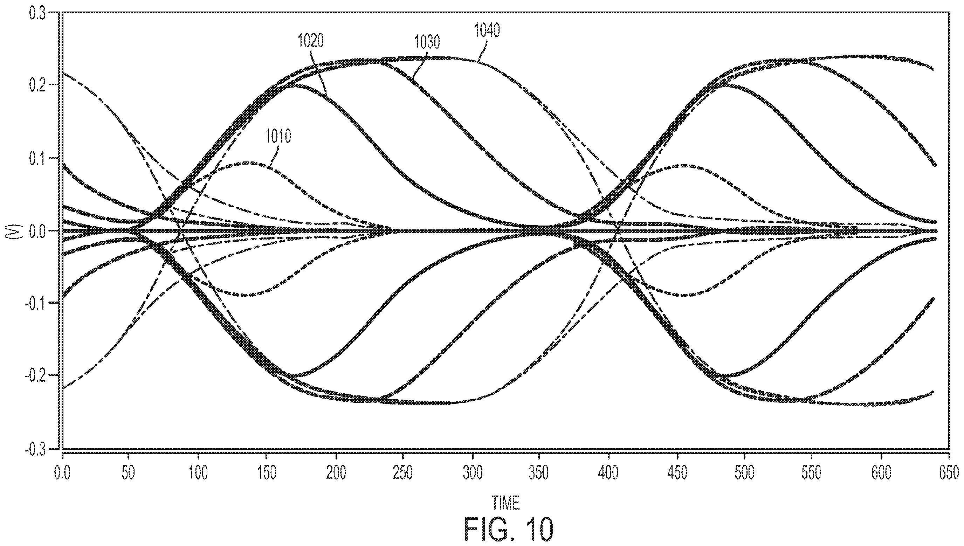

As illustrated in Figure 10, there is a direct correlation between the length of the parallel portion of the non-contact track and its equivalent capacitance. Thus, line 1010 corresponds to a length of about 2.5 mm and a capacitance of less than 0.1 pF, line 1020 corresponds to a length of about 7.5 mm and a capacitance of about 0.2 pF, line 1030 corresponds to a length of about 12.5 mm and a capacitance of about 0.4 pF, and line 1040 corresponds to a length of about 17.5 mm and a capacitance of about 0.5 pF.

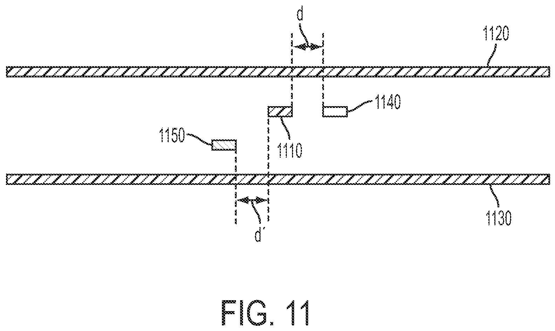

The non-contact track may be formed on the same (signal) layer as the signal line or formed on an adjacent (signal) layer of a multilayer PCB. For example, Figure 11 illustrates a cross-section through layers of a PCB, in which a signal line 1110 is formed on a signal layer between two reference planes 1120 and 1130. A non-contact track may be formed on the signal layer as an edge-side coupler 1140 (at a distance d from the signal line 1110), or may be formed in another adjacent layer as a broadside/diagonal coupler 1150 (at a distance d' from the signal line 1110).

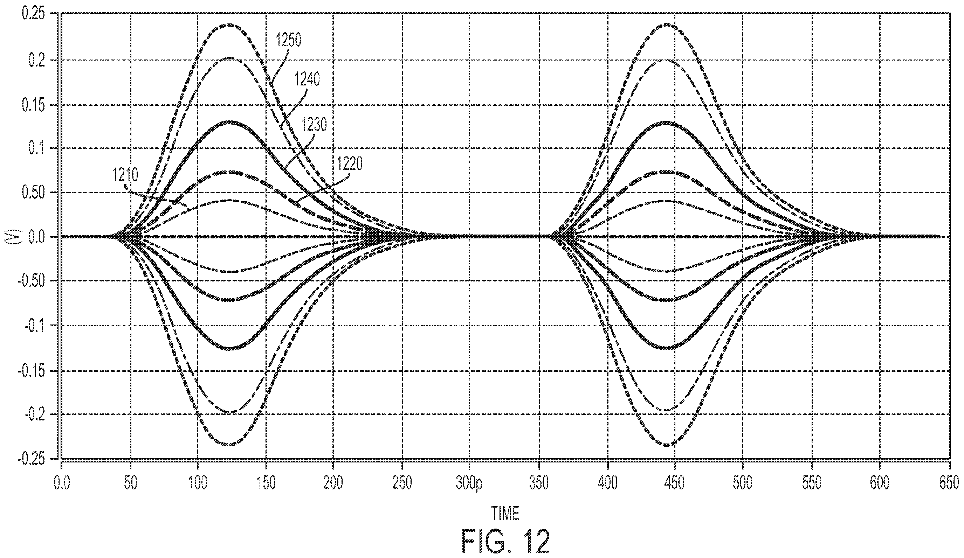

A maximum voltage of the crosstalk signal depends on the coupling coefficient K_{b}, which is proportional to a distance between the signal line and the parallel portion of the non-contact track. For the purpose of illustration and not of limitation, Figure 12 illustrates amplitude of signals for testing track including a parallel portion (broadside/diagonal coupler) having a length of 5 mm and a width of 100 µm for a signal rate of 3.125 Gbps. Line 1210 corresponds to a distance (d' in Figure 11) between the signal line and the testing track of 300 µm, line 1220 corresponds to a side distance between the signal line and the parallel portion of the testing track of 200 µm, line 1230 corresponds to a distance between the signal line and the parallel portion of the testing track of 100 µm, line 1240 corresponds to a distance between the signal line and the parallel portion of the testing track of 0 µm (i.e., the signal line and the parallel portion are edge-aligned while being in different layers) and line 1250 corresponds to a distance between the signal line and the parallel portion of the testing track of -100 µm (i.e., the signal line and the parallel portion overlap while being in different layers).

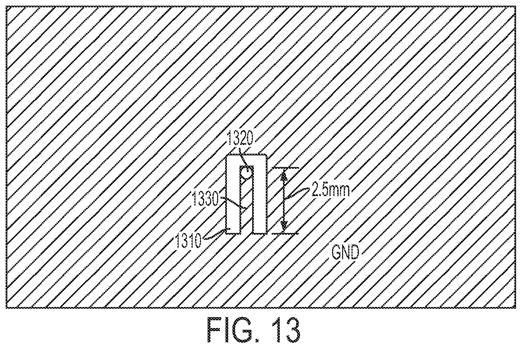

A testing track of a non-contact testing device may be formed by carving (i.e., etching) the metallic layer of a ground layer. For example, in Figure 13, a moat 1310 of a 300 µm width is carved from a ground layer for a length of about 2.5 mm. A contact point 1320 may be formed at the end of middle portion 1330 which is the parallel portion of a non-contact testing device. Thus, the contact point 1320 is formed away from the non-carved surface of the reference layer.

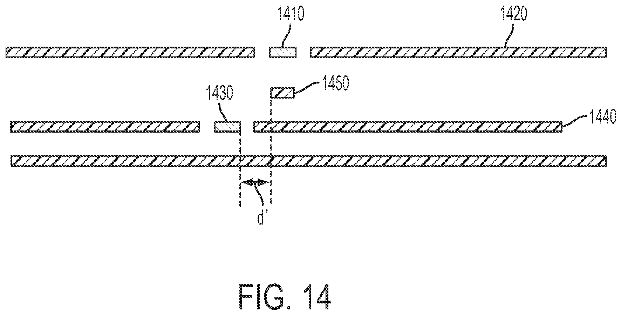

Figure 14 illustrates a cross-section through a multi-layer PCB including exemplary embodiments of non-contact tracks formed on ground layers. Thus, a parallel portion 1410 is illustrated as being formed on a ground layer 1420 and another parallel portion 1430 is illustrated as being formed on a shadow ground layer 1440. The parallel portions 1410 and 1430 are formed to test a signal transmitted along the signal line 1450.

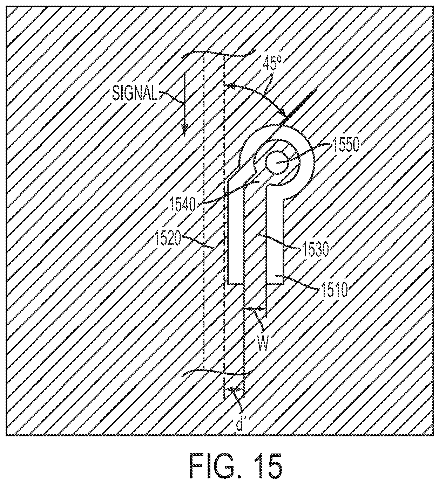

In another more complex embodiment illustrated in Figure 15, a moat 1510 is carved at a side distance d' of about 120 µm from a location of a signal line 1520 located on an adjacent signal layer. The width w of a parallel portion 1530 of the non-contact testing track may be about 120 µm. In a multilayer PCB, the ends of the parallel portions may not be suitable for forming a via from which the testing signal to be measured outside of the PCB. Therefore, the non-contact track may be extended to a location where the via can be formed. In Figure 15, such an extension 1540 is illustrated for a track formed at 45° relative to the parallel portion 1530, away from the signal line 1520. The via 1550 is formed at an end of the extension 1540.

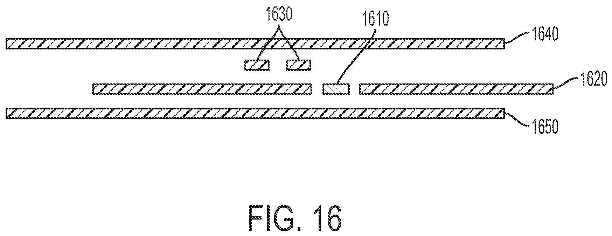

Figure 16 illustrates another embodiment where a non-testing track 1610 is formed on an AC-ground (DC-power) reference layer 1620 to test signals transmitted via differential lines 1630 located between the reference planes 1640 and 1650.

Briefly recapitulating, non-contact testing devices can use different topologies and geometries to maximize coupling coefficient without loading the tested devices and minimize the effect on the tested signals.

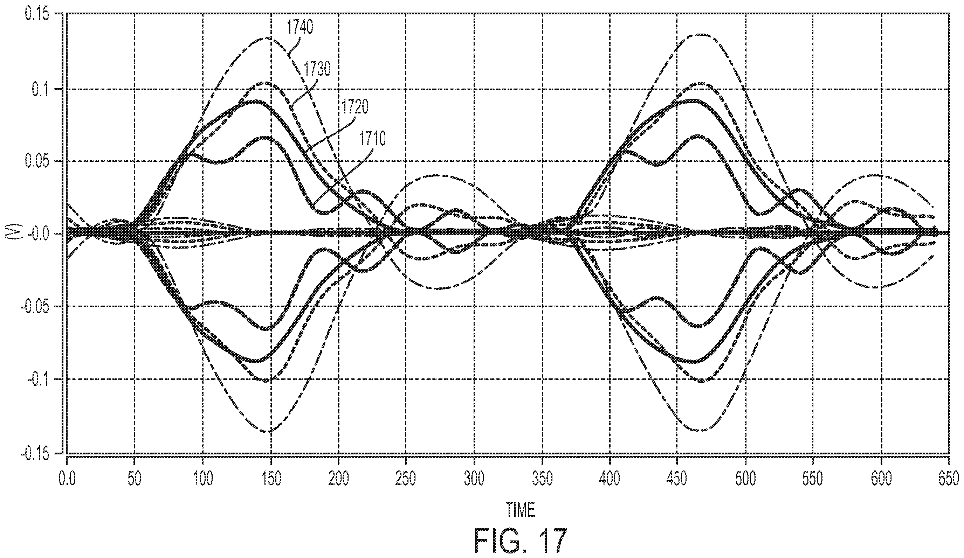

Besides, different lengths, distances to the signal lines, width location and manner of forming the non-contact testing tracks, the manner in which a non-contact testing track is terminated at an end opposite to where a contact point is located has impact relative to the shape and quality of the crosstalk signal. Thus, a non-contact testing track may have an open end, may be shorted or may be terminated via an impedance. In case there are two (differential) parallel portions as illustrated in figure 4, the non-contact testing tracks may be terminated in the same manner or may be terminated differently. Figure 17 illustrates for the same length of the parallel portions (i.e., about 2.5 mm) and the same data signal rate (of 3.125 Gbps), the evolution of the crosstalk signal depending on the manners in which two (differential) non-contact testing tracks are terminated. Line 1710 corresponds to both non-contact testing tracks being open, line 1720 corresponds to both non-contact testing tracks being terminated via impedances, line 1730 corresponds to one of the non-contact testing tracks being open and the other being shorted and line 1740 corresponds to both non-contact testing tracks being shorted.

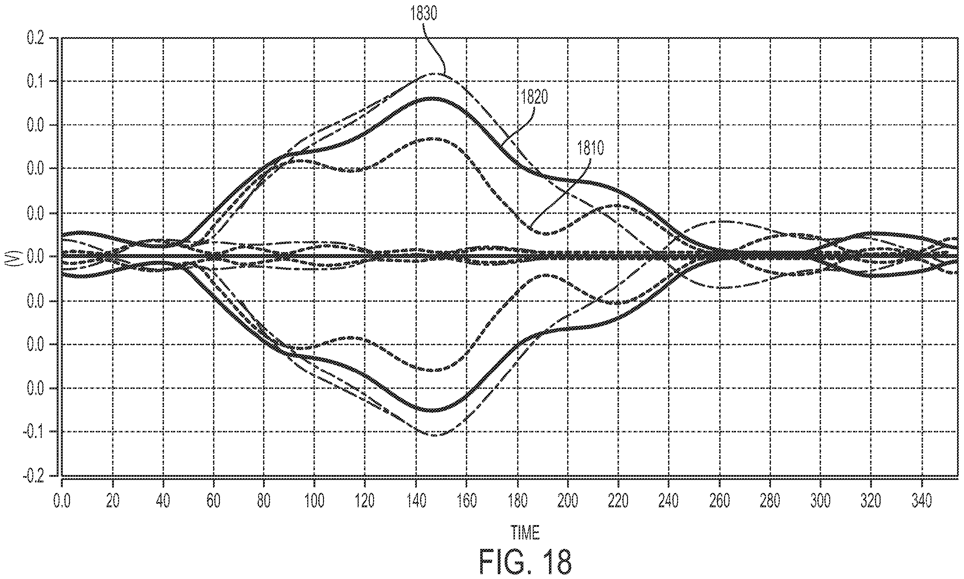

If non-contact testing tracks are shorted to the ground, crosstalk signal amplitude increases because the edge of a derivative coupled signal is boosted inductively. Forming the non-contact testing tracks by carving on reference planes has the advantage that the tracks are shorted directly to the AC ground or ground potential without the use of vias. This advantage is illustrated in Figure 18, where line 1810 corresponds to non-contact testing tracks which are open (i.e., not terminated or shorted), line 1820 corresponds to the case in which the non-contact testing tracks are shorted to a ground potential using a via, and line 1830 corresponds to non-contact testing tracks being formed on a ground plane (i.e., shorted without a via). When the non-contact testing tracks are carved on reference planes, the return path integrity and electromagnetic boundary conditions for printed-circuit mixed-media wave-propagation are preserved using transverse induction. Non-contact testing devices using tracks shorted to ground provide proper potential for charge accumulation under tracks and less disturbance to the propagation field of the tested signal as it satisfy Gauss law for electrical charge.

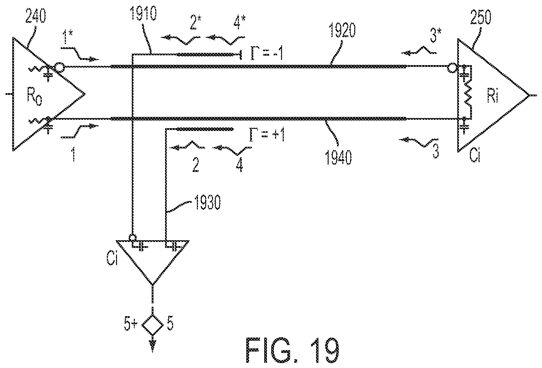

An advantage of using two non-contact testing tracks terminated differently is that the crosstalk signal integrity is enhanced by converting differential-mode noise into common-mode noise that cancels out at the differential receiver inputs. Thus, in Figure 19, a complementary non-contact testing device has a non-contact testing track 1910 coupled to the N-leg 1920 of the signal line shorted, and a non-contact testing track 1930 coupled to the P-leg 1930 of the signal line open. Differential signals 1 and 1* propagate from the driver 240 to the receiver 250. Differential crosstalk signals 2 and 2* emerge from the parallel portions of the non-contact testing tracks. Differential-mode noise 3 and 3* reflected from the receiver 250 are converted into common-mode noise due to the short-open end connections of the non-contact testing tracks. Common-mode noise 4 and 4* cancel out at the differential inputs of the receiver 250. Differential test signals 5 and 5* emerge with improved signal quality due to cancellation of secondary reflections.

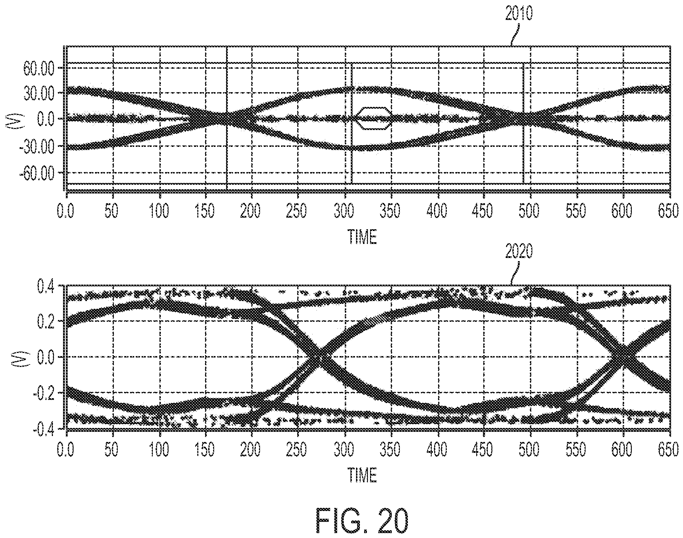

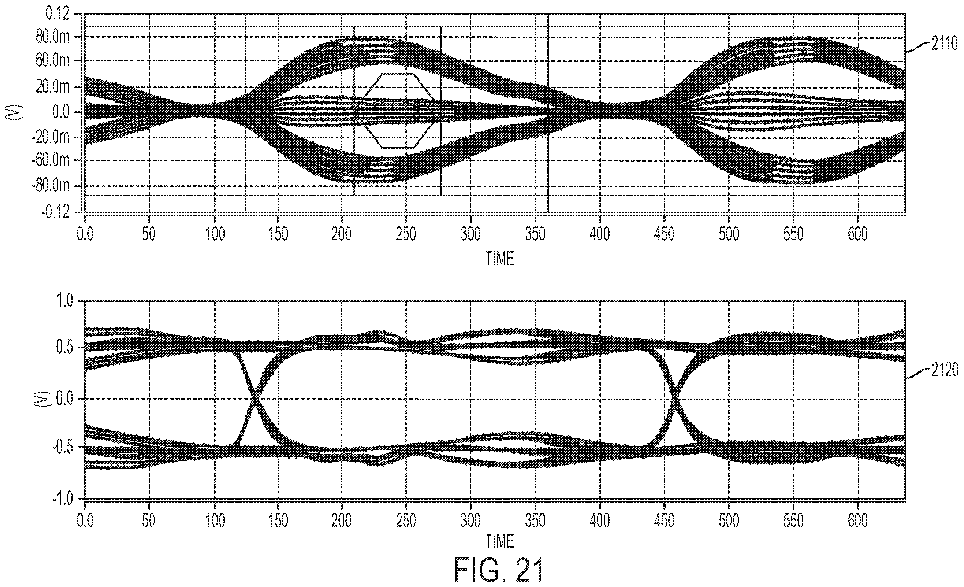

Another variation in the use of the non-contact testing devices is related to the position along a signal line where non-contact testing tracks are formed. Depending on the parameters of the tested signal that are sought to be tested, a non-contact testing device (i.e., the parallel portion of the non-contact testing track) may be located closer to the driver or closer to the receiver. Figure 20 exemplarily illustrates simulations of a signal reaching a receiver (graph 2020) and of a corresponding crosstalk signal (graph 2010) acquired by a non-contact testing device located close to the receiver. Figure 21 exemplarily Illustrates simulations of a signal output by a driver (graph 2120) and of a corresponding crosstalk signal (graph 2110) acquired by a non-contact testing device located close to the driver.

The disclosed exemplary embodiments set forth non-contact testing devices for testing integrity of a signal transmitted on a PCB line.

## Claims

1. A method (100) of testing high-speed signals propagating along at least one signal track on a signal layer of a printed circuit board (PCB), comprising:
forming (S110) a non-contact testing track on a layer of the PCB, the non-contact testing track having at least one portion substantially parallel with the at least one signal track; and
connecting (S120) a testing point to an end of the non-contact testing track to enable measuring a crosstalk signal corresponding to the tested signal,
**characterized in that**
the at least one signal track comprises two differential signal tracks, and the non-contact testing track comprises two non-contact testing tracks located at equal electrical length from the driver relative to the two differential signal tracks, wherein the two non-contact testing tracks have different reflection coefficients and are connected to a differential amplifier.

2. The method of claim 1, wherein the layer on which the non-contact testing track is formed is a different layer of the PCB than the signal layer, the different layer being adjacent to the signal layer where the at least one signal track is located.

3. The method of claim 2, wherein the at least one portion of the non-contact testing track is formed on a side of the at least one signal track, in a projection perpendicular to the signal layer.

4. The method (150) of claim 1, wherein:
the step of forming a non-contact testing track on the layer of the PCB comprises carving (S160) a moat on a reference layer adjacent to the signal layer; and
the step of connecting a testing point to an end of the non-contact testing track comprises connecting (S170) the testing point away from a non-carved surface of the reference layer, to enable measuring the crosstalk signal corresponding to the tested signal.

5. The method of claim 1 or claim 4, further comprising:
forming at least one other non-contact testing track having at least one portion substantially parallel with the at least one signal track, at another location along the at least one signal track;
measuring one other crosstalk signal corresponding to the tested signal, at another testing point connected to an end of the other non-contact testing track; and
outputting sequentially the crosstalk signal and the other crosstalk signal, to diagnose of an integrity of the testing signal along the at least one signal track.

6. The method of claim 1 or claim 4, further comprising: forming a via from the testing point to a surface of the PCB, preferably wherein the non-contact testing track is formed to include another portion configured to prolong the at least one portion substantially parallel with the at least one signal track, to a location which is available for the via.

7. A non-contact testing device (200) formed on a printed circuit board (PCB), to enable testing high-speed signals propagating along at least one signal track (210) located on a signal layer of the PCB, the device comprising:
a non-contact testing track (220) formed on a layer of the PCB, and having at least one portion (222) substantially parallel with the at least one signal track (210); and
a testing point (230) located at an end of the non-contact testing track (220)
**characterized in that**
the at least one single track comprises two differential signal tracks, and the non-contact testing track comprises two non-contact testing tracks located at equal electrical length from the driver relative to the two differential signal tracks, wherein the two non-contact testing tracks have different reflection coefficients and are connected to a differential amplifier.

8. The method of claim 1 or the non-contact testing device of claim 7, wherein a length of the at least one portion of the non-contact testing track, which portion is parallel with the at least one signal track, enables generating the crosstalk signal at a limit between a saturation crosstalk regime and a non-saturation crosstalk regime, when the tested signal has an expected data rate.

9. The non-contact testing device of claim 7, wherein the layer on which the non-contact testing track is located is a different layer of the PCB than the signal layer, the different layer being adjacent to the signal layer where the at least one signal track is located.

10. The method of claim 2 or the non-contact testing device of claim 9, wherein the different layer is another signal layer.

11. The method of claim 2 or the non-contact testing device of claim 9, wherein the at least one portion of the non-contact testing track overlays the at least one signal track.

12. The non-contact testing device of claim 9, wherein the at least one portion of the non-contact testing track is located on a side of the at least one signal track, in a projection perpendicular to the signal layer.

13. The method of claim 1 or the non-contact testing device of claim 7, wherein the at least one portion of the non-contact testing track is formed in the signal layer where the at least one signal track is located.

14. The method of claim 1 or the non-contact testing device of claim 7, wherein the non-contact testing track is open at an end opposite the end where the testing point is located.

15. The method of claim 1 or the non-contact testing device of claim 7, wherein the non-contact testing track is connected to an AC ground potential, at an end opposite the end where the testing point is located.

16. The method of claim 1 or the non-contact testing device of claim 7, wherein the non-contact testing track is terminated via an impedance to an AC ground potential, at an end opposite the end where the testing point is located.

17. The method of claim 1 or the non-contact testing device of claim 7, wherein the at least one portion of the non-contact testing track is located close to a driver end of the at least one signal track.

18. The method of claim 1 or the non-contact testing device of claim 7, wherein the non-contact testing track is located close to a receiver end of the at least one signal track.

19. The method of claim 1 or the non-contact testing device of claim 7, wherein the two non-contact testing tracks are each open, connected to a ground potential or terminated via an impedance to a ground potential at an end opposite the end where a respective testing point is connected.

20. The non-contact testing device (200) of claim 7, wherein:
the non-contact testing track (220) is formed by etching a moat (1310) on a reference layer of the PCB, the reference layer (1420, 1440) being adjacent to the signal layer, and the non-contact testing track (220) having at least one portion (222) substantially parallel with the at least one signal track (210); and
the testing point (230, 1320) is located at an end of the non-contact testing track (220) away from a non-carved surface of the reference layer.

21. The method of claim 4 or the non-contact testing device of claim 20, wherein the reference layer is a ground layer a power layer, or a shadow ground polygon.

22. The non-contact testing device of claim 7 or claim 20, further comprising:
at least one other non-contact testing track having at least one portion substantially parallel with the at least one signal track, at another location along the at least one signal track;
a signal collector configured to output sequentially the crosstalk signal generated in the at least one portion of the at least one non-contact testing track and another crosstalk signal generated in the at least one portion of the at least one other non-contact testing track, to diagnose of an integrity of the testing signal along the at least one signal track.

23. The non-contact testing device of claim 7 or claim 20, further comprising:
a via connecting the testing point to a surface of the PCB.

24. The non-contact testing device of claim 7 or claim 22, wherein the non-contact testing track has another portion configured to prolong the at least one portion substantially parallel with the at least one signal track to a location which is available for the via.

## Patentansprüche

1. Verfahren (100) zum Prüfen von Hochgeschwindigkeitssignalen, die sich entlang mindestens einer Signalspur auf einer Signalschicht einer Leiterplatte (PCB) ausbreiten, umfassend:
Bilden (S110) einer kontaktlosen Prüfspur auf einer Schicht der PCB, wobei die kontaktlose Prüfspur mindestens einen Abschnitt aufweist, der im Wesentlichen parallel zu der mindestens einen Signalspur verläuft; und
Verbinden (S120) einer Prüfstelle mit einem Ende der kontaktlosen Prüfspur, um das Messen eines Übersprechsignals zu ermöglichen, das dem geprüften Signal entspricht,
**dadurch gekennzeichnet, dass**
die mindestens eine Signalspur zwei Differentialsignalspuren umfasst und die kontaktlose Prüfspur zwei kontaktlose Prüfspuren umfasst, die sich im gleichen elektrischen Abstand vom Treiber relativ zu den beiden Differentialsignalspuren befinden, wobei die beiden kontaktlosen Prüfspuren verschiedene Reflexionskoeffizienten aufweisen und mit einem Differentialverstärker verbunden sind.

2. Verfahren nach Anspruch 1, wobei die Schicht, auf der die kontaktlose Prüfspur gebildet wird, eine von der Signalschicht verschiedene Schicht der PCB ist, wobei die verschiedene Schicht an die Signalschicht angrenzt, auf der sich die mindestens eine Signalspur befindet.

3. Verfahren nach Anspruch 2, wobei der mindestens eine Abschnitt der kontaktlosen Prüfspur an einer Seite der mindestens einen Signalspur in einem Vorsprung gebildet wird, der rechtwinklig zur Signalschicht verläuft.

4. Verfahren (150) nach Anspruch 1, wobei:
der Schritt des Bildens einer kontaktlosen Prüfspur auf der Schicht der PCB Bahnen (S160) eines Grabens auf einer Referenzschicht umfasst, die an die Signalschicht angrenzt; und
der Schritt des Verbindens einer Prüfstelle mit einem Ende der kontaktlosen Prüfspur Verbinden (S170) der Prüfstelle von einer ungebahnten Fläche der Referenzschicht entfernt umfasst, um das Messen des Übersprechsignals zu ermöglichen, das dem geprüften Signal entspricht.

5. Verfahren nach Anspruch 1 oder Anspruch 4, ferner umfassend:
Bilden mindestens einer weiteren kontaktlosen Prüfspur, die mindestens einen Abschnitt aufweist, der im Wesentlichen parallel zu der mindestens einen Signalspur verläuft, an einer weiteren Stelle entlang der mindestens einen Signalspur;
Messen eines weiteren Übersprechsignals, das dem geprüften Signal entspricht, an einer weiteren Prüfstelle, die mit einem Ende der weiteren kontaktlosen Prüfspur verbunden ist; und
nacheinander Ausgeben des Übersprechsignals und des weiteren Übersprechsignals, um eine Integrität des Prüfsignals entlang der mindestens einen Signalspur zu analysieren.

6. Verfahren nach Anspruch 1 oder Anspruch 4, ferner umfassend:
Bilden einer Bohrung von der Prüfstelle zu einer Fläche der PCB, wobei vorzugsweise die kontaktlose Prüfspur gebildet ist, um einen weiteren Abschnitt zu beinhalten, der ausgelegt ist, den mindestens einen Abschnitt, der im Wesentlichen parallel zu der mindestens einen Signalspur verläuft, zu einer Stelle zu verlängern, die für die Bohrung verfügbar ist.

7. Kontaktlose Prüfvorrichtung (200), die auf einer Leiterplatte (PCB) gebildet ist, um das Prüfen von Hochgeschwindigkeitssignalen zu ermöglichen, die sich entlang mindestens einer Signalspur (210) ausbreiten, die sich auf einer Signalschicht der PCB befindet, wobei die Vorrichtung Folgendes umfasst:
eine kontaktlose Prüfspur (220), die auf einer Schicht der PCB gebildet ist, und die mindestens einen Abschnitt (222) aufweist, der im Wesentlichen parallel zu der mindestens einen Signalspur (210) verläuft; und
eine Prüfstelle (230), die sich an einem Ende der kontaktlosen Prüfspur (220) befindet,
**dadurch gekennzeichnet, dass**
die mindestens eine einzelne Spur zwei Differentialsignalspuren umfasst, und die kontaktlose Prüfspur zwei kontaktlose Prüfspuren umfasst, die sich im gleichen elektrischen Abstand vom Treiber relativ zu den beiden Differentialsignalspuren befinden, wobei die beiden kontaktlosen Prüfspuren verschiedene Reflexionskoeffizienten aufweisen und mit einem Differentialverstärker verbunden sind.

8. Verfahren nach Anspruch 1 oder kontaktlose Prüfvorrichtung nach Anspruch 7, wobei eine Länge des mindestens einen Abschnitts der kontaktlosen Prüfspur, deren Abschnitt parallel zu der mindestens einen Signalspur verläuft, das Erzeugen des Übersprechsignals an einer Grenze zwischen einem Sättigungsübersprechregime und einem Nichtsättigungsübersprechregime ermöglicht, wenn das geprüfte Signal eine erwartete Datenrate aufweist.

9. Kontaktlose Prüfvorrichtung nach Anspruch 7, wobei die Schicht, auf der sich die kontaktlose Prüfspur befindet, eine von der Signalschicht verschiedene Schicht der PCB ist, wobei die verschiedene Schicht dort an die Signalschicht angrenzt, wo sich die mindestens eine Signalspur befindet.

10. Verfahren nach Anspruch 2 oder kontaktlose Prüfvorrichtung nach Anspruch 9, wobei die verschiedene Schicht eine weitere Signalschicht ist.

11. Verfahren nach Anspruch 2 oder kontaktlose Prüfvorrichtung nach Anspruch 9, wobei der mindestens eine Abschnitt der kontaktlosen Prüfspur die mindestens eine Signalspur überlagert.

12. Kontaktlose Prüfvorrichtung nach Anspruch 9, wobei sich der mindestens eine Abschnitt der kontaktlosen Prüfspur an einer Seite der mindestens einen Signalspur in einem Vorsprung befindet, der rechtwinklig zur Signalschicht verläuft.

13. Verfahren nach Anspruch 1 oder kontaktlose Prüfvorrichtung nach Anspruch 7, wobei der mindestens eine Abschnitt der kontaktlosen Prüfspur in der Signalschicht gebildet wird, in der sich die mindestens eine Signalspur befindet.

14. Verfahren nach Anspruch 1 oder kontaktlose Prüfvorrichtung nach Anspruch 7, wobei die kontaktlose Prüfspur an einem Ende offen ist, das sich gegenüber dem Ende befindet, an dem sich die Prüfstelle befindet.

15. Verfahren nach Anspruch 1 oder kontaktlose Prüfvorrichtung nach Anspruch 7, wobei die kontaktlose Prüfspur mit einem Wechselstrommassepotential an einem Ende verbunden ist, das sich gegenüber dem Ende befindet, an dem sich die Prüfstelle befindet.

16. Verfahren nach Anspruch 1 oder kontaktlose Prüfvorrichtung nach Anspruch 7, wobei die kontaktlose Prüfspur über einen Widerstand zu einem Wechselstrommassepotential an einem Ende beendet wird, das sich gegenüber dem Ende befindet, an dem sich die Prüfstelle befindet.

17. Verfahren nach Anspruch 1 oder kontaktlose Prüfvorrichtung nach Anspruch 7, wobei sich der mindestens eine Abschnitt der kontaktlosen Prüfspur nahe einem Treiberende der mindestens einen Signalspur befindet.

18. Verfahren nach Anspruch 1 oder kontaktlose Prüfvorrichtung nach Anspruch 7, wobei sich die kontaktlose Prüfspur nahe einem Empfängerende der mindestens einen Signalspur befindet.

19. Verfahren nach Anspruch 1 oder kontaktlose Prüfvorrichtung nach Anspruch 7, wobei die beiden kontaktlosen Prüfspuren jeweils offen, mit einem Massepotential verbunden oder über einen Widerstand zu einem Massepotential an einem Ende beendet sind, das sich gegenüber dem Ende befindet, mit dem eine entsprechende Prüfstelle verbunden ist.

20. Kontaktlose Prüfvorrichtung (200) nach Anspruch 7, wobei:
die kontaktlose Prüfspur (220) durch Ätzen eines Grabens (1310) auf eine Referenzschicht der PCB gebildet wird, wobei die Referenzschicht (1420, 1440) an die Signalschicht angrenzt, und die kontaktlose Prüfspur (220) mindestens einen Abschnitt (222) aufweist, der im Wesentlichen parallel zu der mindestens einen Signalspur (210) verläuft; und
die Prüfstelle (230, 1320) sich an einem Ende der kontaktlosen Prüfspur (220) von einer ungebahnten Fläche der Referenzschicht entfernt befindet.

21. Verfahren nach Anspruch 4 oder kontaktlose Prüfvorrichtung nach Anspruch 20, wobei die Referenzschicht eine Masseschicht, eine Stromschicht oder ein Schattenmassepolygon ist.

22. Kontaktlose Prüfvorrichtung nach Anspruch 7 oder Anspruch 20, ferner umfassend:
mindestens eine weitere kontaktlose Prüfspur, die mindestens einen Abschnitt, der im Wesentlichen parallel zu der mindestens einen Signalspur verläuft, an einer weiteren Stelle entlang der mindestens einen Signalspur aufweist;
einen Signalsammler, der ausgelegt ist, das Übersprechsignal, das in dem mindestens einen Abschnitt der mindestens einen kontaktlosen Prüfspur erzeugt wurde, und ein weiteres Übersprechsignal, das in dem mindestens einen Abschnitt der mindestens einen weiteren kontaktlosen Prüfspur erzeugt wurde, nacheinander auszugeben, um eine Integrität des Prüfsignals entlang der mindestens einen Signalspur zu analysieren.

23. Kontaktlose Prüfvorrichtung nach Anspruch 7 oder Anspruch 20, ferner umfassend:
eine Bohrung, welche die Prüfstelle mit einer Fläche der PCB verbindet.

24. Kontaktlose Prüfvorrichtung nach Anspruch 7 oder Anspruch 22, wobei die kontaktlose Prüfspur einen weiteren Abschnitt aufweist, der ausgelegt ist, den mindestens einen Abschnitt, der im Wesentlichen parallel zu der mindestens einen Signalspur verläuft, zu einer Stelle zu verlängern, die für die Bohrung verfügbar ist.

## Revendications

1. Procédé (100) de test de signaux à grande vitesse se propageant le long d'au moins une piste de signal sur une couche de signal d'une carte de circuit imprimé (PCB), comprenant :
la formation (S110) d'une piste de test sans contact sur une couche de la PCB, la piste de test sans contact ayant au moins une partie sensiblement parallèle à l'au moins une piste de test ; et
la connexion (S120) d'un point de test à une extrémité de la piste de test sans contact pour permettre la mesure d'un signal de diaphonie correspondant au signal testé,
**caractérisé en ce que**
l'au moins une piste de signal comprend deux pistes de signal différentielles, et la piste de test sans contact comprend deux pistes de test sans contact situées à une longueur électrique égale du pilote relativement aux deux pistes de signal différentielles, dans lequel les deux pistes de test sans contact ont des coefficients de réflexion différents et sont reliés à un amplificateur différentiel.

2. Procédé selon la revendication 1, dans lequel la couche sur laquelle la piste de test sans contact est formée est une couche différente de la PCB que la couche de signal, la couche différente étant adjacente à la couche de signal dans laquelle l'au moins une piste de signal est située.

3. Procédé selon la revendication 2, dans lequel l'au moins une partie de la piste de test sans contact est formée sur un côté de l'au moins une piste de signal, dans une projection perpendiculaire à la couche de signal.

4. Procédé (150) selon la revendication 1, dans lequel :
l'étape de formation d'une piste de test sans contact sur la couche de la PCB comprend la découpe (S160) d'un fossé sur une couche de référence adjacente à la couche de signal ; et l'étape de connexion d'un point de test à une extrémité de la piste de test sans contact comprend la connexion (S170) du point de test en s'éloignant d'une surface non découpée de la couche de référence, pour permettre la mesure du signal de diaphonie correspondant au signal testé.

5. Procédé selon la revendication 1 ou la revendication 4, comprenant également :
la formation d'au moins une autre piste de test sans contact ayant au moins une partie sensiblement parallèle à l'au moins une piste de signal, au niveau d'un autre emplacement le long de l'au moins une piste de signal ;
la mesure d'un autre test de diaphonie correspondant au signal testé, au niveau d'un autre point de test relié à une extrémité de l'autre piste de test sans contact ; et
l'émission séquentielle du signal de diaphonie et de l'autre signal de diaphonie, pour diagnostiquer une intégrité du signal de test le long de l'au moins une piste de signal.

6. Procédé selon la revendication 1 ou la revendication 4, comprenant également :
la formation d'un trou d'interconnexion à partir du point de test vers une surface de la PCB, de préférence dans lequel la piste de test sans contact est formée pour comprendre une autre partie conçue pour prolonger l'au moins une partie sensiblement parallèle à l'au moins une piste de signal, vers un emplacement qui est disponible pour le trou d'interconnexion.

7. Dispositif de test sans contact (200) formé sur une carte de circuit imprimé (PCB), pour permettre le test de signaux à grande vitesse se propageant le long d'au moins une piste de signal (210) situé sur une couche de signal de la PCB, le dispositif comprenant :
une piste de test sans contact (220) formée sur une couche de la PCB, et ayant au moins une partie (222) sensiblement parallèle à l'au moins une piste de signal (210) ; et
un point de test (230) situé au niveau d'une extrémité de la piste de test sans contact (220)
**caractérisé en ce que**
l'au moins une piste unique comprend deux pistes de signal différentielles, et la piste de test sans contact comprend deux pistes de test sans contact situées à une longueur électrique égale du pilote relativement aux deux pistes de signal différentielles, dans lequel les deux pistes de test sans contact ont des coefficients de réflexion différents et sont reliés à un amplificateur différentiel.

8. Procédé selon la revendication 1 ou le dispositif de test sans contact selon la revendication 7, dans lequel une longueur de l'au moins une partie de la piste de test sans contact, laquelle partie est parallèle à l'au moins une piste de signal, permet la génération du signal de diaphonie au niveau d'une limite entre un régime de diaphonie de saturation et un régime de diaphonie de non saturation, lorsque le signal testé a un débit de données attendu.

9. Dispositif de test sans contact selon la revendication 7, dans lequel la couche sur laquelle la piste de test sans contact est formée est une couche différente de la PCB que la couche de signal, la couche différente étant adjacente à la couche de signal dans laquelle l'au moins une piste de signal est située.

10. Procédé selon la revendication 2 ou dispositif de test sans contact selon la revendication 9, dans lequel la couche différente est une autre couche de signal.

11. Procédé selon la revendication 2 ou dispositif de test sans contact selon la revendication 9, dans lequel l'au moins une partie de la piste de test sans contact recouvre l'au moins une piste de signal.

12. Dispositif de test sans contact selon la revendication 9, dans lequel l'au moins une partie de la piste de test sans contact est située sur un côté de l'au moins une piste de signal, dans une projection perpendiculaire à la couche de signal.

13. Procédé selon la revendication 1 ou dispositif de test sans contact selon la revendication 7, dans lequel l'au moins une partie de la piste de test sans contact est formée dans la couche de signal dans laquelle l'au moins une piste de signal est située.

14. Procédé selon la revendication 1 ou dispositif de test sans contact selon la revendication 7, dans lequel la piste de test sans contact est ouverte au niveau d'une extrémité opposée à l'extrémité au niveau de laquelle le point de test est situé.

15. Procédé selon la revendication 1 ou dispositif de test sans contact selon la revendication 7, dans lequel la piste de test sans contact est connectée à un potentiel de masse en CA au niveau d'une extrémité opposée à l'extrémité au niveau de laquelle le point de test est situé.

16. Procédé selon la revendication 1 ou dispositif de test sans contact selon la revendication 7, dans lequel la piste de test sans contact est terminée à travers une impédance vers un potentiel de masse en CA au niveau d'une extrémité opposée à l'extrémité au niveau de laquelle le point de test est situé.

17. Procédé selon la revendication 1 ou dispositif de test sans contact selon la revendication 7, dans lequel l'au moins une partie de la piste de test sans contact est située à proximité d'une extrémité de pilote de l'au moins une piste de signal.

18. Procédé selon la revendication 1 ou dispositif de test sans contact selon la revendication 7, dans lequel la piste de test sans contact est située à proximité d'une extrémité de récepteur de l'au moins une piste de signal.

19. Procédé selon la revendication 1 ou dispositif de test sans contact selon la revendication 7, dans lequel les deux pistes de test sans contact sont chacune ouverte, connectée à un potentiel de masse ou terminée à travers une impédance vers un potentiel de masse au niveau d'une extrémité opposée à l'extrémité au niveau de laquelle un point de test respectif est connecté.

20. Dispositif de test sans contact (200) selon la revendication 7, dans lequel :
la piste de test sans contact (220) est formée en gravant un fossé (1310) sur une couche de référence de la PCB, la couche de référence (1420, 1440) étant adjacente à la couche de signal, et la piste de test sans contact (220) ayant au moins une partie (222) sensiblement parallèle à l'au moins une piste de signal (210) ; et
le point de test (230, 1320) est situé au niveau d'une extrémité de la piste de test sans contact (220) en s'éloignant d'une surface non découpée de la couche de référence.

21. Procédé selon la revendication 4 ou dispositif de test sans contact selon la revendication 20, dans lequel la couche de référence est une couche de masse, une couche d'alimentation ou un polygone de terre fantôme.

22. Dispositif de test sans contact selon la revendication 7 ou la revendication 20, comprenant également :
au moins une autre piste de test sans contact ayant au moins une partie sensiblement parallèle à l'au moins une piste de signal, au niveau d'un autre emplacement le long de l'au moins une piste de signal ;
un collecteur de signal conçu pour émettre séquentiellement le signal de diaphonie généré dans l'au moins une partie de l'au moins une piste de test sans contact et un autre signal de diaphonie généré dans l'au moins une partie de l'au moins une autre piste de test sans contact, pour diagnostiquer une intégrité du signal de test le long de l'au moins une piste de signal.

23. Dispositif de test sans contact selon la revendication 7 ou la revendication 20, comprenant également :
un trou d'interconnexion reliant le point de test à une surface de la PCB.

24. Dispositif de test sans contact selon la revendication 7 ou la revendication 22, dans lequel la piste de test sans contact a une autre partie conçue pour prolonger l'au moins une partie sensiblement parallèle à l'au moins une piste de signal vers un emplacement qui est disponible pour le trou d'interconnexion.
